# EUROPEAN PATENT SPECIFICATION

(11) **EP 4 352 840 B1**
(45) Date of publication and mention of the grant of the patent: **14.01.2026**
(21) Application number: 22736358.7
(22) Date of filing: 02.06.2022
(51) Int. Cl.: H01S 5/14, H01S 3/08, H01S 5/06, H01S 3/10, H01S 5/0687, H01S 5/065, H01S 5/024

(54) **TUNABLE LONG COHERENCE LASER LOCKED TO A MICRORESONATOR VIA SELF-INJECTION**
ABSTIMMBARER LASER MIT LANGER KOHÄRENZ, DER DURCH SELBSTINJEKTION AN EINEN MIKRORESONATOR VERRIEGELT WIRD
LASER À COHÉRENCE LONGUE ACCORDABLE VERROUILLÉ À UN MICRORÉSONATEUR PAR AUTO-INJECTION

(30) Priority: 07.06.2021 US 202163197567 P
(43) Date of publication of application: 17.04.2024
(73) Proprietor: Soreq Nuclear Research Center, 8180000 Yavne (IL)
(72) Inventor: YACOBY, Eyal, 8180000 Yavne (IL); SFEZ, Bruno, 8180000 Yavne (IL)
(74) Representative: Wright, Howard Hugh Burnby
(86) International application number: PCT/IB2022/055165
(87) International publication number: WO 2022/259101

(56) References cited:
- US-A1- 2012 194 893
- US-A1- 2019 146 091
- US-A1- 2020 313 389
- PAVLOV N G ET AL: "Narrow linewidth lasing and soliton Kerr-microcombs with ordinary laser diodes", ARXIV.ORG, CORNELL UNIVERSITY LIBRARY, 201 OLIN LIBRARY CORNELL UNIVERSITY ITHACA, NY 14853, 26 September 2018 (2018-09-26), XP081087611, DOI: 10.1038/S41566-018-0277-2

## Description

### FIELD OF THE INVENTION

The present invention relates to tunable, long coherent length lasers.

### BACKGROUND OF THE INVENTION

Tunable, long coherent length laser sources are required for many applications such as spectroscopy, holographic metrology, quantum measurements, three-dimensional digital holographic metrology, as well as for medical applications, such as acousto-optic imaging. Highly tunable ( > 200 nm) narrow linewidth lasers are available, where the state of the art lasers are based on a Littman-Metcalf configuration, in which spectral tuning is achieved by mechanical tuning of an internal back reflector mirror. However, the high cost and large sizes of these devices are a significant drawback. In contrast to the prior art, the present invention aims to provide a low cost and compact tunable laser device.

US2019146091A1 describes an underwater lidar.

US2020313389A1 describes a laser device and method of transforming laser spectrum.

US2012194893A1 describes a tunable photonic microwave or radio frequency receivers based on electro-optic optical whispering gallery mode resonators.

### SUMMARY OF THE INVENTION

In one aspect, an apparatus in accordance with claim 1 is provided. In another aspect, a method in accordance with claim 6 is provided. The present invention provides a low cost and compact tunable single laser source. A multimode diode laser (with a single transverse mode) is optically locked to a single Whispering Gallery Mode (WGM) of a micro-resonator via self-injection feedback. The tunability of the WGM-locked laser is achieved by locking the diode laser to different WGMs of the microresonator. The WGMs are selected by tuning the temperature and polarization of the laser source. In addition, the WGMs are tuned mechanically, or by controlling the temperature of the microresonator using a feedback control system. Simultaneous control of the laser source temperature and of the microresonator' s WGMs achieves a continuous tunability for the WGM-locked laser wavelength.

### BRIEF DESCRIPTION OF THE DRAWINGS

The present invention will be understood and appreciated more fully from the following detailed description, taken in conjunction with the drawings in which:

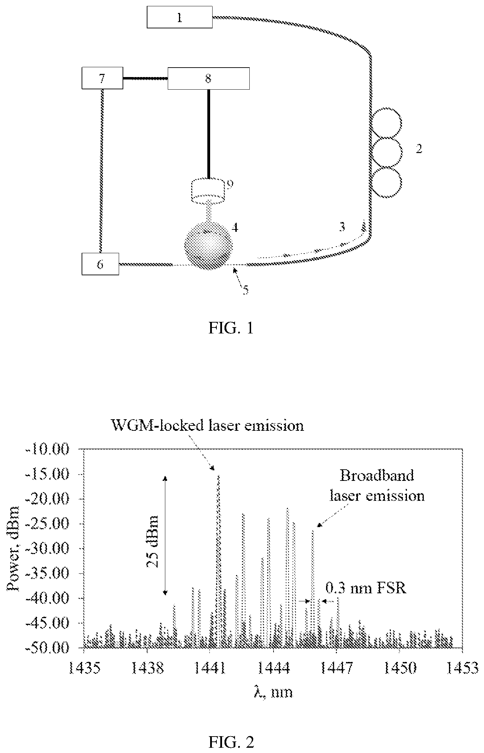

Fig. 1 is a simplified schematic of the laser system. The components are: 1. A commercial fiber-coupled multimode diode laser with temperature control. 2. Polarization Controller (PC). 3. Coherent self-injection feedback. 4. Microresonator with a mechanical/temperature-based tuning system. 5. Tapered optical fiber. 6. Optical spectrum analyzer. 7. Photodetector. 8. Feedback control system. 9. Thermoelectric system for temperature control.
Fig. 2 is a graphical illustration of the laser spectrum at a temperature of 20 °C. (solid line) The broadband laser emission consists of - 30 longitudinal modes with free spectral range (FSR) of ~ 0.3 nm. (dashed line) WGM-locked laser emission at a laser temperature of 20 °C with a side-mode suppression ratio of 25 dB.

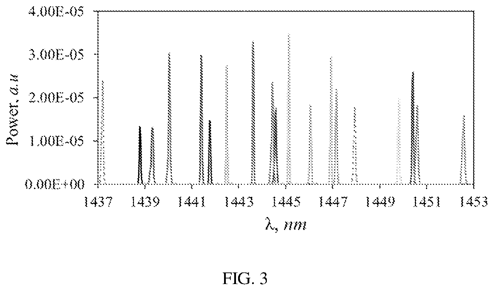

Fig. 3 is a graphical illustration of tuning the WGM-locked laser over a range of 15 nm. The tunability is achieved by locking the laser to 19 different WGMs.

### DETAILED DESCRIPTION OF THE INVENTION

The schematic of the experimental setup is presented in Fig. 1. A commercial fiber-coupled multimode laser diode (single transverse mode) with a thermoelectric cooler is used. The laser beam is locked to a microresonator with high Q factor (10⁸ ≥ Q ≥ 10⁵) and with a feedback control system that tunes the microresonator's WGMs. Some of the light which is coupled into the microresonator is backscattered into the laser, providing feedback and locking the laser to a specific mode of the microresonator. In order to impede unwanted optical feedbacks to the laser source, FC-APC (fiber channel-angled physical contact) fiber connectors are used.

Generally, the low coherent light source excites multiple WGMs simultaneously; however, by fine tuning of the laser temperature, it is possible to shift the comb of the multimode laser lines relatively to the comb of the microresonator's WGMs so that only one WGM perfectly coincides with a laser line, and hence, to obtain single mode lasing via optical feedback of the laser mode.

In order to tune the wavelength of the narrowed single mode laser, the multimode laser source is locked to various WGMs of the microresonator; the WGMs to which the laser is locked can belong to different mode families. This is done by tuning the temperature of the laser source, which in turn, shifts the spectrum of the emitted light. As a consequence, the overlap between the spectral lines of the broadband laser and of the microsphere WGMs changes and different WGMs are excited. In addition, controlling the polarization of the laser source makes it possible to determine whether to excite TE (transverse electric) or TM (transverse magnetic) WGMs, and increases the number of possible modes to which the laser can couple, thus increasing the tunability of the laser.

The WGMs are tuned as well by controlling the temperature of the microresonator or by changing the shape of the microresonator (mechanically). In both cases, the optical path of the WGM is changed due to a change in the radius of the microresonator and in the effective refractive index of the mode. However, the mechanical route can provide a higher tuning speeds (>kHz) than can be achieved via temperature. Mechanical tuning of WGMs is achieved by applying a tensile stress on a microresonator with fiber tails at both ends, according to the following steps:
1. Hold one of the fiber tails of the microresonator on a static stage.
2. Hold one of the fiber tails of the microresonator on a single axis piezo system.
3. Bring a tapered fiber in contact with the microresonator to achieve optical coupling. The tapered fiber must be transverse to the fiber tails of the microresonator.
4. Tune the WGMs of the microresonator by applying a voltage signal to the piezo system.

Simultaneous control of the laser source temperature and of the microresonator WGMs can achieve a continuous tunability for the WGM-locked laser wavelength. "Dead zones" in the spectrum are avoided as long as the tuning range of the WGMs is larger than the spacing between all two adjacent modes. In that case, the continuous tuning is performed by simultaneous and equal shifting of the laser comb and of the WGMs comb after the locking is obtained.

The procedure of the laser locking and tuning is as follows;
1. Define the desired laser wavelength. The desired laser wavelength must exist within the tunability range of the device (~ 15 nm).
2. Find the closest microresonator's WGM to the desired laser wavelength.
3. Bring the microresonator to its pre-modified (initial) conditions (temperature\tensile stress).
4. Set the temperature and polarization of the laser to lock the laser to that closest WGM.
5. Tune the laser temperature and the microresonator's WGM simultaneously using a feedback control system that ensures the stability of the locking during the spectral tuning process.
6. Stop the tuning process when the desired laser wavelength is obtained.

The ability to tune the single mode laser by locking it to different WGMs is achievable only where the ratio between the light wavelengths squared and the microresonator diameter is comprised between 1 and 100 for which the FSR is of ~ 0.2 - 20 nanometers, and the spacing between different WGMs is large. However, for larger microresonators, with a significantly smaller spacing between the WGMs, shifting the frequency comb of the laser to obtain single mode coupling to one mode of the dense WGMs of the microresonator is much more challenging, thus tuning this laser by locking to different individual modes, is not practical.

The linewidth of the WGM-locked single mode laser scales as 1/Q². However, increasing the microresonator Q factor narrows the linewidth of the WGM (Δν = v/Q), and thus decreases the spectral overlap between the WGM and the broadband laser emission. Consequently, the feedback power, which is essential for initiating the laser locking, is decreased. Reduction in the feedback power set a crucial limit to the laser locking procedure as it prevents the locking of the laser to certain WGMs for which the optical feedback is not strong enough to suppress the other laser modes. For that reason, the tunability range of the laser device is reduced as the Q factor of the microresonator increases. For a tunability range of more than 1 nm, microresonator with 10⁸ ≥ Q ≥ 10⁵ is required.

### Example

The inventors used a fiber-coupled butterfly mounted multimode diode laser with a central wavelength at λ₀ ~ 1445 nm and bandwidth of Δλ_{FWHM} ~ 5 nm (Qphotonics) (FWHM - full width at half maximum). The temperature of the laser may be controlled using a thermoelectric cooler with temperature tunability range of 0°C - 60°C. The tuning of the laser temperature shifts the central wavelength of the multimode laser beam by 0.5 nm per 1°C. The spectrum of the multimode laser at a temperature of 20 °C and output power of ~ 2 mW is presented in Fig. 2 (solid line). The spectrum consists of ~ 30 longitudinal modes with FSR of 0.3 nm.

The laser beam may be locked to a silica microsphere with a diameter of ~ 30 - 35 µm, and a Q factor of Q ~ 10⁶. The WGM-locked laser emission at a laser temperature of 20 °C is shown in Fig. 2 (dashed line). The narrowed laser emission is concentrated in a single line (1441.4 nm) with a side-mode suppression ratio of 25 dB, being the wavelength where one of the laser lines coincides with a microresonator TE WGM.

Fig. 3 shows 19 different WGM-locked laser modes over a range of ~ 15 nm, measured with an optical spectrum analyzer. The laser lines are obtained at different times, for different laser temperatures from 15 °C to 35 °C, and different polarizations. By controlling the polarization of the laser it is possible to excite TE and TM WGMs, hence to improve the tunability of the laser. The laser lines presented in Fig. 3 are not equally spaced, as they represent WGMs of different mode families. As mentioned above, this featured may make the device suitable for applications such as three-dimensional digital holographic metrology, for which a laser source with non-uniformly spaced laser lines is advantageous.

**Table. 1. Relevant parameters in the example**

| Parameter | Symbol | Value |
|---|---|---|
| Laser central wavelength | λ₀ | 1445 nm |
| Laser linewidth | Δλ_{FWHM} | 5 nm |
| Laser temperature tunability range | | 0°C - 60°C (0.5 nm per 1°C) |
| Laser output power | | 2 mW |
| Laser Free spectral range | | 0.3 nm |
| Microresonator (sphere) diameter | D | 30 - 35 µm |
| Microresonator Q factor | Q | 10⁶ |

## Claims

1. An apparatus comprising:
a longitudinal multimode, single transverse mode fiber coupled laser diode (1),
an optical fiber (5) with a tapered region, coupled to the said diode,
a microresonator (4) in contact with the tapered region of said fiber (5),
a polarization controller (2) that controls the polarization of the light in the tapered region, a first temperature controller (9) that controls temperature and wavelength of the laser diode (1),
a device for modifying the whispering gallery modes, WGM, distribution of the microresonator (4), and
a control feedback system (8) configured to adjust the modes distribution of the microresonator (4), said control feedback system (8) being further configured to find the closest microresonator's (4) WGM to a desired laser wavelength, to bring the microresonator (4) to its pre-modified initial conditions of temperature or tensile stress, to set the temperature and polarization of the laser to lock the wavelength of the laser to that closest WGM, this being called the WGM-locked laser wavelength, and to achieve a continuous tunability for the WGM-locked laser wavelength by tuning the laser source temperature and the microresonator's (4) WGM simultaneously.

2. The apparatus according to claim 1, wherein said control feedback system (8) is configured to ensure lasing stability.

3. The apparatus according to claim 2, wherein said control feedback system (8) is configured to continuously scan said WGM-locked laser diode (1) wavelength through said first temperature controller (9).

4. The apparatus according to claim 1, wherein said device is a temperature controller (9).

5. The apparatus according to claim 1, wherein said device is based on a mechanically tunable microresonator (4) with two stretchable fiber tails and a piezo system.

6. A method of operating the apparatus according to anyone of claims 1-5 so as to obtain a tunable long coherence laser, comprising:
defining a desired laser wavelength, said desired laser wavelength being within a tunability range of said tunable long coherence laser;
finding the closest microresonator's (4) WGM to the desired laser wavelength;
bringing the microresonator (4) to its pre-modified initial conditions of temperature or tensile stress;
setting the temperature and polarization of the laser to lock the laser to that closest WGM, this being called the WGM-locked laser wavelength;
achieving a continuous tunability for the WGM-locked laser wavelength by tuning the laser source temperature and the microresonator's (4) WGM simultaneously using a feedback control system (8) that ensures the stability of the locking during the spectral tuning process; and
stopping the tuning process when the desired laser wavelength is obtained.

7. The method according to claim 6, wherein the laser is locked to a microresonator (4) with mechanical tuning, according to the following steps:
holding one of the fiber tails of the microresonator (4) on a static stage;
holding one of the fiber tails of the microresonator (4) on a single axis piezo system;
bringing a tapered fiber in contact with the microresonator (4) to achieve optical coupling, wherein said tapered fiber is transverse to the fiber tails of the microresonator (4); and
tuning the WGMs of the microresonator (4) by applying a voltage signal to the piezo system.

## Patentansprüche

1. Einrichtung, umfassend:
eine fasergekoppelte Multi-Mode-, Single-Mode-Longitudinal-Laserdiode (1),
eine optische Faser (5) mit einem sich verjüngenden Bereich, die mit der Diode gekoppelt ist,
einen Mikroresonator (4), der mit dem sich verjüngenden Bereich der Faser (5) in Kontakt steht,
eine Polarisationssteuerung (2), die die Polarisation des Lichts im verjüngten Bereich steuert, eine erste Temperatursteuerung (9), die die Temperatur und die Wellenlänge der Laserdiode (1) steuert,
eine Vorrichtung zum Modifizieren der Verteilung der Flüstergalerie-Moden, WGM, des Mikroresonators (4), und
ein Rückkopplungs-Steuerungssystem (8), das konfiguriert ist, um die Modenverteilung des Mikroresonators (4) anzupassen, wobei das Rückkopplungs-Steuerungssystem (8) weiter konfiguriert ist, um die WGM des nächstgelegenen Mikroresonators (4) zu einer gewünschten Laserwellenlänge zu ermitteln, den Mikroresonator (4) in seinen vor der Modifikation bestehenden Ausgangszustand hinsichtlich Temperatur oder Zugspannung zu versetzen, die Temperatur und die Polarisation des Lasers so zu verriegeln, dass die Wellenlänge des Lasers an diesen nächstgelegenen WGM gekoppelt wird, wobei dies als die WGM-verriegelte Laserwellenlänge bezeichnet wird, und um eine kontinuierliche Abstimmbarkeit für die WGM-verriegelte Laserwellenlänge zu erreichen, indem die Temperatur der Laserquelle und der WGM des Mikroresonators (4) gleichzeitig abgestimmt werden.

2. Einrichtung nach Anspruch 1, wobei das Rückkopplungs-Steuerungssystem (8) so konfiguriert ist, dass es die Stabilität der Lasertätigkeit sicherstellt.

3. Einrichtung nach Anspruch 2, wobei das Rückkopplungs-Steuerungssystem (8) so konfiguriert ist, dass es die Wellenlänge der WGM-verriegelten Laserdiode (1) über die erste Temperatursteuerung (9) kontinuierlich abtastet.

4. Einrichtung nach Anspruch 1, wobei die Vorrichtung eine Temperatursteuerung (9) ist.

5. Einrichtung nach Anspruch 1, wobei die Vorrichtung auf einem mechanisch abstimmbaren Mikroresonator (4) mit zwei dehnbaren Faser-Pigtails und einem Piezosystem basiert.

6. Verfahren zum Betreiben der Einrichtung nach einem der Ansprüche 1-5, um einen abstimmbaren Laser mit langer Kohärenz zu erhalten, umfassend:
Definieren einer gewünschten Laserwellenlänge, wobei die gewünschte Laserwellenlänge innerhalb eines Abstimmbarkeitsbereichs des abstimmbaren Lasers mit langer Kohärenz liegt;
Ermitteln der WGM des nächstgelegenen Mikroresonators (4) zu der gewünschten Laserwellenlänge;
Versetzen des Mikroresonators (4) in seinen vor der Modifizierung bestehenden Ausgangszustand hinsichtlich Temperatur oder Zugspannung;
Einstellen der Temperatur und der Polarisation des Lasers, um den Laser auf die nächstgelegene WGM zu fixieren, wobei diese als WGM-verriegelte Laserwellenlänge bezeichnet wird;
Erreichen einer kontinuierlichen Abstimmbarkeit für die WGM-verriegelte Laserwellenlänge durch gleichzeitiges Abstimmen der Laserquellentemperatur und der WGM des Mikroresonators (4) unter Verwendung eines Rückkopplungs-Steuerungssystems (8), das die Stabilität der Fixierung während des Spektralabstimmungsprozesses gewährleistet; und
Beenden des Abstimmvorgangs, wenn die gewünschte Laserwellenlänge erhalten wurde.

7. Verfahren nach Anspruch 6, wobei der Laser an einem Mikroresonator (4) mit mechanischer Abstimmung verriegelt wird, gemäß den folgenden Schritten:
Halten eines der Faser-Pigtails des Mikroresonators (4) in einer statischen Phase;
Halten eines der Faser-Pigtails des Mikroresonators (4) auf einem einachsigen Piezo-System;
Versetzen einer konischen Faser in Kontakt mit dem Mikroresonator (4), um eine optische Kopplung zu erreichen, wobei die konische Faser sich quer zu den Faser-Pigtails des Mikroresonators (4) befindet; und
Abstimmen der WGMs des Mikroresonators (4) durch Anlegen eines Spannungssignals an das Piezosystem.

## Revendications

1. Appareil comprenant :
une diode laser couplée à une fibre à mode transversal simple, à multimode longitudinal (1),
une fibre optique (5) avec une région conique, couplée à ladite diode,
un microrésonateur (4) en contact avec la région conique de ladite fibre (5),
un dispositif de commande de polarisation (2) qui commande la polarisation de la lumière dans la région conique, un premier dispositif de commande de température (9) qui commande une température et une longueur d'onde de la diode laser (1),
un dispositif destiné à modifier la distribution de modes de voûte acoustique, WGM, du microrésonateur (4), et
un système de rétroaction de commande (8) configuré pour ajuster la distribution de modes du microrésonateur (4), ledit système de rétroaction de commande (8) étant en outre configuré pour trouver le WGM du microrésonateur (4) le plus proche sur une longueur d'onde laser souhaitée, pour amener le microrésonateur (4) à ses conditions initiales prémodifiées de température ou de résistance à la traction, pour régler une température et une polarisation du laser afin de verrouiller la longueur d'onde du laser sur ce WGM le plus proche, cela étant appelé la longueur d'onde de laser à WGM verrouillé et pour obtenir une accordabilité continue pour la longueur d'onde de laser à WGM verrouillé en accordant la température de source de laser et le WGM du microrésonateur (4) simultanément.

2. Appareil selon la revendication 1, dans lequel ledit système de rétroaction de commande (8) est configuré pour assurer une stabilité de laser.

3. Appareil selon la revendication 2, dans lequel ledit système de rétroaction de commande (8) est configuré pour balayer en continu ladite longueur d'onde de diode laser (1) à WGM verrouillé par le biais dudit premier dispositif de commande de température (9).

4. Appareil selon la revendication 1, dans lequel ledit dispositif est un dispositif de commande de température (9).

5. Appareil selon la revendication 1, dans lequel ledit dispositif est basé sur un microrésonateur accordable mécaniquement (4) avec deux queues extensibles en fibre et un système piézoélectrique.

6. Procédé d'exploitation de l'appareil selon l'une quelconque des revendications 1 à 5 de façon à obtenir un laser à longue cohérence accordable, comprenant :
la définition d'une longueur d'onde de laser souhaitée, ladite longueur d'onde de laser souhaitée étant au sein d'une plage d'accordabilité dudit laser à longue cohérence accordable ;
le fait de trouver le WGM du microrésonateur (4) le plus proche de la longueur d'onde de laser souhaitée ;
le fait de mettre le microrésonateur (4) dans ses conditions initiales prémodifiées de température ou de résistance à la traction ;
le réglage de la température et de la polarisation du laser pour verrouiller le laser sur ce WGM le plus proche, cela étant appelé la longueur d'onde de laser à WGM verrouillé ;
l'obtention d'une accordabilité continue pour la longueur d'onde de laser à WGM verrouillé en accordant la température de source de laser et le WGM du microrésonateur (4) à l'aide d'un système de commande de rétroaction (8) qui garantit la stabilité du verrouillage pendant le processus d'accordage spectral ; et
l'arrêt du processus d'accordage lorsque la longueur d'onde de laser souhaitée est obtenue.

7. Procédé selon la revendication 6, dans lequel le laser est verrouillé sur un microrésonateur (4) avec un accordage mécanique, selon les étapes suivantes :
maintien d'une des queues de fibre du microrésonateur (4) sur un étage statique ;
maintien d'une des queues de fibre du microrésonateur (4) sur un système piézoélectrique à axe unique ;
mise d'une fibre conique en contact avec le microrésonateur (4) pour obtenir un couplage optique, dans lequel ladite fibre conique est transversale aux queues de fibre du microrésonateur (4) ; et
accord des WGM du microrésonateur (4) en appliquant un signal de tension au système piézoélectrique.
